Europäisches Patentamt

European Patent Office

Office européen des brevets

(11) Publication number: **0 415 586 A2**

# EUROPEAN PATENT APPLICATION

(21) Application number: 90308831.8

(51) Int. Cl.5: **H01L 41/24**

(22) Date of filing: 10.08.90

(30) Priority: 30.08.89 GB 8919557

(43) Date of publication of application:
06.03.91 Bulletin 91/10

(84) Designated Contracting States:
DE FR GB

(71) Applicant: THE PLESSEY COMPANY plc
Vicarage Lane
Ilford Essex, IG1 4AQ(GB)

(72) Inventor: Chilton, John Andrew
16 Bishops Dr.
Kettering, Northants, NN15 6AL(GB)
Inventor: Garner, Geoffrey Michael
5 Cheriton Way
Northampton, Northants, NN1 5SB(GB)

(74) Representative: Pope, Michael Bertram
Wingate
The General Electric Company, p.l.c., GEC
Patent Dept.(Wembley Office), Hirst
Research Centre, East Lane
Wembley Middlesex HA9 7PP(GB)

(54) Improved electro-active composite poling efficiency.

(57) This invention describes a technique for improving the effectiveness of 'poling' of a composite material and hence its degree of electrical activity. The technique utilises a preferential uptake of a polar fluid by one of the phases to reversibly alter the resistivity balance between the materials within the composite. The fluid may be driven off after poling by, for instance, vacuum drying to allow operation of the material as a low electrical loss material.

## IMPROVED ELECTRO-ACTIVE COMPOSITE POLING EFFICIENCY

This invention relates to a method of producing composite material for piezoelectric devices.

Piezoelectric ceramics are widely used in transducer applications ranging from simple piezoelectric buzzers to complex multilayer actuators. They are also extensively utilised in underwater transducer applications such as hydrophones and transmitters. Although they have large $d_{33}$ piezoelectric coefficients, these materials often have poor hydrostatic piezoelectric cofficients due to the coupling of the $d_{ij}$ tensor elements. In some applications, their high permittivites are undesirable because this leads to a low voltage coefficient ($g_h = d_h/\epsilon$). Their high densities also prevent good impedance matching to water. Finally, being brittle ceramics, they require sintering or hot pressing and subsequent machining operations to achieve the required shape and in many cases a more compliant material with greater shock resistance would be preferred.

One possible way of obviating these undesirable properties is to produce a composite material in which an electro-active powder is dispersed in a polymeric phase. This so-called 0-3 composite approach offers distinct advantages for many uses since the polymeric phase lowers the permittivity and density of the material, making the composite more suitable for underwater applications. The presence of the polymer phase also increases the compliance of the composite and offers the possibility of processing by the more economical plastics technology such as compression, transfer and injection moulding. Using this approach, the fabrication of complex shapes is much easier than by conventional ceramic processing techniques. In particular, the manufacture of large area hydrophones is greatly simplified. These composite materials also have potential for IR sensing applications.

The dispersion of an electro-active powder (such as PZT, PbTiO₃, etc) into a polymeric matrix is such that the individual particles of the powder are effectively isolated from each other in all dimensions by a continuously connected polymer. In order to align this random distribution of particles, such materials are generally 'poled' by the application of high DC electric fields. During the poling stage of the composite materials the dipoles of the active material are aligned in the direction of the electric field applied thereto.

For an array of electro-active particles dispersed into a carrier, the potential acting across an isolated particle is given by:

$$V_1/V_0 = \frac{1}{(\rho_2/\rho_1 \cdot d_1/d_2 + 1)}$$

where $V_1$ and $V_0$ are the potential across the particle and the composite respectively $\rho_1$ and $\rho_2$ are the resistivities of the particle and polymer respectively and $d_1$ and $d_2$ are dimensional factors (see reference Newnham R.E. et al, Mat. Res. Bull., Vol 13, 525, 1978), the ratio of which can be approximated to unity. Consequently, if the resistivity of the particle is much lower than the polymer (as it tends to be for ceramics such as PbTiO₃, PZT, etc) only a small fraction of the applied field is applied to the electro-active phase.

Various methods have been proposed to reduce the resistivity of the polymer system used, typically incorporating dopants such as carbon, germanium or silicon into the polymer matrix. Also, lower resistivity polymers have been used to closely match the polymer resistivity to that of the ceramic.

However, these approaches permanently reduce the resistivity of the polymer matrix. In many transducer applications, it is desirable to maintain the highest resistivity possible in the polymer matrix to minimise the contribution to the dielectric loss of the composite and hence reduce the electrical noise generated. Also, the higher the resistivity of the polymer, the higher the loading of the conducting phase that is required to achieve a resistivity balance. At levels above 1.5vol% loading the dielectric loss increases rapidly, making application of large fields increasingly difficult.

According to the invention, there is provided a method of producing a composite material for piezoelectric devices which comprises forming a composite material including an electro-active material and a non-electro-active material and applying an electric field to pole the composite material, characterised by previously exposing said composite material to a polar fluid before the electric field is applied to pole the composite material and thereafter driving off the polar fluid from the composite material, the polar fluid being preferentially absorbed by the non-electro-active material rather than the electro-active material and being effective to lower the resistivity of the non-electro active material, the resistivity of the non-electro-active material being restored after driving off the polar fluid.

The electrical resistivity of the non-electro-active phase in a composite material is reversibly reduced, such that an improved resistivity match between the non-electro-active and electro-active phases is obtained during poling and the high resistivity (low electrical loss) of the non-electro-active phase is retained during operation as a device.

It is possible to select a polar fluid which is highly preferentially absorbed by the inactive rather than the active phase. By deliberately exposing the composite material to the fluid prior to poling, the effective resistivity of the non-electro-active phase can be decreased and the resistivity balance between the two phases can approach (or become greater than) unity. In contrast to the above methods, this procedure is reversible and after poling the polar fluid can be driven off (usually by vacuum drying) and the desirable high resistivity regained. In this way, high purity, high resistivity non-electro-active phases can be utilised in composite fabrication and these can provide both the resistivity balance required for poling to suitable activity and the high resistivities required to produce low loss composites for low loss transducers.

The non-electro-active material may be a thermoplastic polymer or a thermosetting polymer and the ceramic material may be a piezoelectric ceramic.

Preferably the polar fluid includes water, dimethyl formamide, methyl cynanide, dimethyl acetamide, diethyl carbonate; the active material includes lead titanate (pure or modified), PZT (pure or modified), PLZT (pure or modified) and barium titanate (pure or modified), and the non-electro-active material includes epoxide resin systems, silicone rubber systems, polyimide systems and ethylene-vinyl acetate polymers.

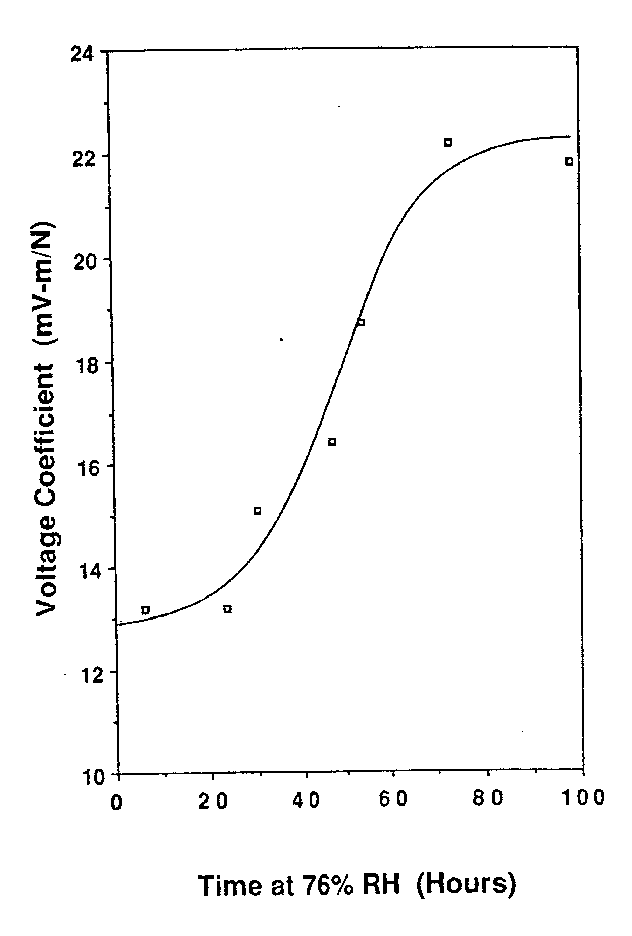

Solely as an example of the invention to illustrate its application and in no way to limit its scope a specific example will now be described with reference to the accompanying drawing which is a graph showing the variation of piezoelectric voltage coefficient with exposure time up to a time of 100 hours.

Modified lead titanate powder well mixed with an epoxide resin system (optionally assisted by the use of a chosen coupling agent, such as a silane or a titanate) is used to form an active composite. An amine cured bisphenol-A epoxy resin is a suitable non-electro-active phase. The composite is cured in a mould under pressure (possibly using temperature to fully react the resin).

A composite plate has been prepared as above and allowed to dry in a desiccator containing a phosphorus pentoxide drying agent. This plate was cut into eight samples, each one of which was electroded ready for poling. A suitable electrode system would be silver DAG - a proprietary silver loaded conductive coating, which could be painted on and allowed to dry. Poling leads could be attached in a similar way. After further drying, the samples were placed in a 76% relative humidity atmosphere. Water in the atmosphere is used as a polar fluid. The samples were thereafter poled by applying electric field thereto. The remains of the polar fluid were removed after poling and thereafter the sensisitivity was measured. The variation of piezoelectric voltage coefficient ($g_h$) with an exposure time up to 100 hours is seen in the drawing. As the exposure time increases, the value of $g_h$ increases until saturation is reached at a time of 75 hours. A sensitivity gain of around 5dB has been achieved at 75 hours of exposure time by using this technique to produce more efficient poling.

## Claims

1. A method of producing a composite material for piezoelectric devices which comprises forming a composite material including an electro-active material and a non-electro-active material and applying an electric field to pole the composite material, characterised by exposing said composite material to a polar fluid, applying the electric field to pole the composite material and thereafter driving off the polar fluid from the composite material, the polar fluid being preferentially absorbed by the non- electro-active material rather than the electro-active material and being effective to lower the resistivity of the non-electro-active material, the resistivity of the non-electro-active material being restored after driving off the polar fluid.

2. A method as claimed in claim 1, in which the electro-active material is a piezoelectric ceramic material.

3. A method as claimed in claim 2, in which the ceramic material is lead titanate (pure or modified), PZT (pure or modified), PLZT (pure or modified) or barium titanate (pure or modified).

4. A method as claimed in any one of the preceding claims, in which the non-electro-active material is a thermoplastic polymer or a thermosetting polymer.

5. A method as claimed in claim 4, in which the polymer is an epoxide resin system, a silicone rubber system, polyimide system or ethylene-vinyl acetate polymer.

6. A method as claimed in any one of the preceding claims, in which the polar fluid is water.

7. A method as claimed in any one of claims 1 to 5, in whch the polar fluid is dimethyl formamide, methyl cyanide, dimethyl acetamide or diethyl carbonate or other suitable polar fluid.

8. A method as claimed in any one of the preceding claims, in which the said composite material is formed by dispersing the particles of the electro-active material in the non-electro-active material.

9. A method of forming a composite material for piezoelectric devices, substantially as hereinbefore described.

10. A composite material, when made by a method as claimed in any one of the preceding claims.

11. A piezoelectric device including a composite material as claimed in claim 10.